# EUROPÄISCHE PATENTSCHRIFT

(11) **EP 2 172 082 B1**
(45) Veröffentlichungstag und Bekanntmachung des Hinweises auf die Patenterteilung: **14.10.2020**
(21) Anmeldenummer: 08761219.8
(22) Anmeldetag: 19.06.2008
(51) Int. Cl.: H05B 45/37

(54) **SCHALTUNGSANORDNUNG UND VERFAHREN ZUR ANSTEUERUNG VON LICHTEMITTIERENDEN BAUELEMENTEN**
CIRCUIT ARRANGEMENT AND METHOD FOR CONTROLLING LIGHT-EMITTING COMPONENTS
CIRCUITERIE ET PROCÉDÉ POUR COMMANDER DES COMPOSANTS ÉLECTROLUMINESCENTS

(30) Priorität: 19.06.2007 DE 102007028576; 24.08.2007 DE 102007040151; 29.04.2008 DE 102008001452
(43) Veröffentlichungstag der Anmeldung: 07.04.2010
(73) Patentinhaber: Silicon Line GmbH, 80687 München (DE)
(72) Erfinder: GROEPL, Martin, 87527 Sonthofen / Oberallgaeu (DE)
(74) Vertreter: Hofmann, Andreas
(86) Internationale Anmeldenummer: PCT/EP2008/057784
(87) Internationale Veröffentlichungsnummer: WO 2008/155384

(56) Entgegenhaltungen:
- EP-A- 0 798 828
- WO-A-2007/069103
- WO-A-2008/050779
- DE-B3-102004 032 456
- FR-A- 2 889 643
- GB-A- 2 365 788
- JP-A- 2007 149 874
- US-A- 5 019 769
- US-A1- 2004 195 978
- US-A1- 2004 208 011
- US-A1- 2005 185 428
- US-A1- 2008 012 507

## Beschreibung

### Technisches Gebiet

Die vorliegende Erfindung betrifft allgemein das technische Gebiet der Ansteuerung von lichtemittierenden Bauelementen.

Die vorliegende Erfindung betrifft im Spezielleren eine Schaltungsanordnung, insbesondere Treiberschaltung, gemäß dem Oberbegriff des Anspruchs 1 sowie ein entsprechendes Verfahren zum Ansteuern mindestens eines lichtemittierenden Bauelements (vgl. Druckschrift US 2004/0195978 A1; des Weiteren wird zum diesbezüglichen Stand der Technik auf die EP 0 798 828 A2 und auf die JP 2007-149874 A aufmerksam gemacht).

Im Rahmen der vorliegenden Erfindung wird unter dem Begriff Licht bzw. lichtemittierend nicht nur der für das Auge sichtbare Bereich der elektromagnetischen Strahlung verstanden, der sich in einem Wellenlängenbereich von etwa 380 Nanometer bis etwa 780 Nanometer erstreckt (, was einer Frequenz von etwa 789 Terahertz bis herab zu etwa 385 Terahertz entspricht).

Vielmehr wird unter dem Begriff Licht bzw. lichtemittierend das gesamte, also auch das für das Auge nicht sichtbare elektromagnetische Wellenlängen- bzw. Frequenzspektrum verstanden, insbesondere der I[nfra]R[ot]-Bereich (Wellenlängenbereich bis zu etwa 2.000 Nanometer bzw. Frequenzbereich bis herab zu etwa 150 Terahertz), zum Beispiel eine Wellenlänge von etwa 850 Nanometer bzw. eine Frequenz von etwa 350 Terahertz.

### Stand der Technik

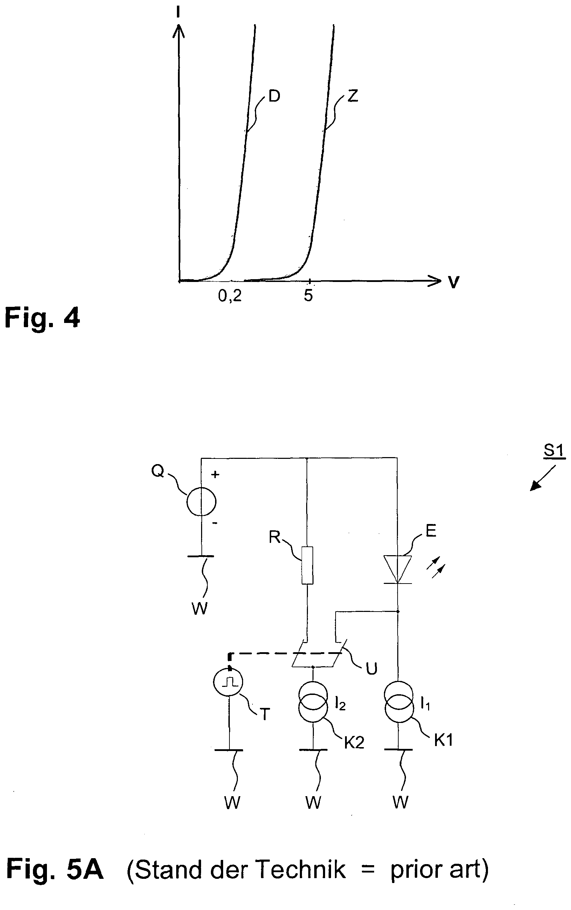

Aus dem Stand der Technik bekannte exemplarische Schaltungsanordnungen zur Ansteuerung eines lichtemittierenden Bauelements E zum Zwecke der Datenübertragung vom lichtemittierenden Bauelement E (= sogenannte Quelle) zu einem lichtempfangenden Bauelement (= sogenannte Senke) sind in Fig. 5A bis Fig. 5C dargestellt.

Typischerweise wird zur optischen Datenübertragung als lichtemittierendes Bauelement E, insbesondere als optisches Sendeelement oder als optische Quelle, ein Halbleiterlaser oder eine Leuchtdiode benutzt.

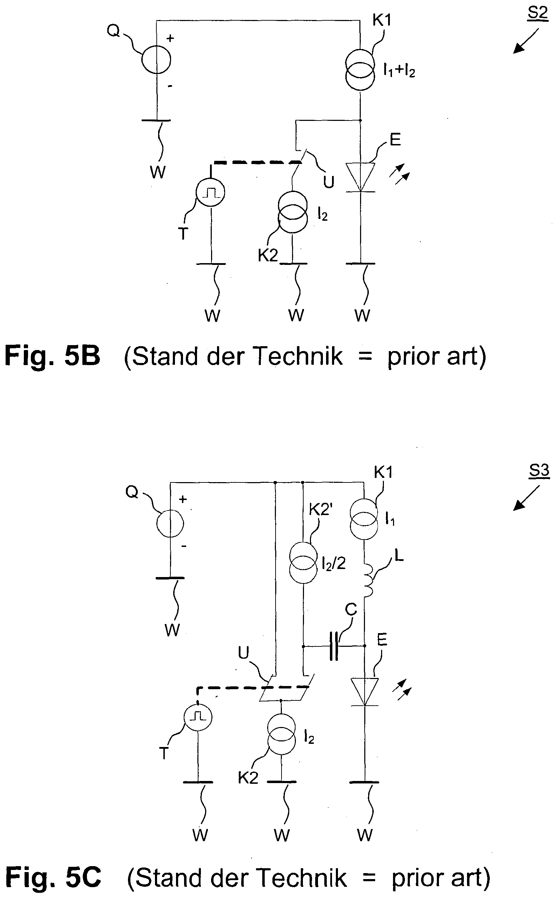

Dieser Halbleiterlaser oder diese Leuchtdiode wird gemäß dem Stand der Technik beispielsweise von einer elektronischen Treiberschaltung S1 (vgl. Fig. 5A), S2 (vgl. Fig. 5B) oder S3 (vgl. Fig. 5C) mit der notwendigen Betriebsspannung, dem Vorstrom (Bias-Strom) und dem Modulationsstrom für den korrekten Betrieb versorgt.

Die Treiberschaltung S1, S2, S3 kann sowohl als eine integrierte Schaltung (oder IC = Integrated Circuit) als auch diskret aus einzelnen Komponenten auf einer Leiterplatte (oder PCB = Printed Circuit Board) aufgebaut sein.

Beim in Fig. 5A gezeigten Beispiel aus dem Stand der Technik kann das lichtemittierende Bauelement E über einen ersten Strompfad I₁ und zusätzlich über einen zweiten Strompfad I₂ mit Strom versorgt werden. Hierzu fließt im ersten Strompfad der Strom I₁ von einer Gleichspannungsquelle Q über das lichtemittierende Bauelement E zu einer Konstantstromquelle K1 für I₁.

Durch Aktivschalten oder Zuschalten des zweiten Strompfads I₂ mittels eines den Strompegel des lichtemittierenden Bauelements E steuernden Umschalters U fließt durch das lichtemittierende Bauelement E der Gesamtstrom I_{ges} = I₁ + I₂, ansonsten der Strom I₁. Zur Stromversorgung des zweiten Strompfads I₂ ist eine Konstantstromquelle K2 vorgesehen.

Die Modulation des lichtemittierenden Bauelements E erfolgt also in Form von Stromeinstellung oder Strommodulation, das heißt durch zeitliches Variieren der durch das lichtemittierende Bauelement E fließenden Stromstärken zwischen den Werten I₁ und I₁ + I₂.

Die Anordnung von Umschalter U und Blindlast R bewirkt, dass am dem Umschalter U in Bezug auf den zweiten Strompfad I₂ zugeordneten Knotenpunkt stets der gleiche Strom fließt, wobei der Strom I₂ in dem Falle, dass der zweite Strompfad I₂ nicht dem lichtemittierenden Bauelement E zugeschaltet ist, in der Blindlast R im Wesentlichen in thermische Energie umgewandelt wird, was beispielsweise zu etwa fünfzig Prozent der Betriebszeit des lichtemittierenden Bauelements der Fall sein kann; allerdings ist der Strom I₂ unvorteilhafterweise auch dann vorhanden, wenn dieser Strom I₂ gar nicht benötigt wird.

Des Weiteren sind beim in Fig. 5A gezeigten Beispiel aus dem Stand der Technik die beiden Konstantstromquellen K1 und K2 im Hochfrequenzpfad (, das heißt nicht im Versorgungspfad) angeordnet, was notwendigerweise parasitäre Kapazitäten nach sich zieht. Auch treten beim in Fig. 5A gezeigten Beispiel aus dem Stand der Technik notwendigerweise ein unerwünschter hoher Spannungsabfall bzw. eine hohe Sättigungsspannung auf.

Bei der in Fig. 5B dargestellten zweiten exemplarischen Treiberschaltung S2 gemäß dem Stand der Technik fließt bei Aktivschalten oder Zuschalten des zweiten Strompfads I₂ mittels des den Strompegels steuernden Einschalters U durch das lichtemittierende Bauelement E der Strom I₁ + I₂, ansonsten der Strom I₁; allerdings ist der Strom I₂ unvorteilhafterweise auch dann vorhanden, wenn dieser Strom I₂ gar nicht benötigt wird.

Die Betriebsspannung des lichtemittierenden Bauelements E hängt von der durch die Spannungsquelle Q zur Verfügung gestellten Versorgungsspannung (= zum Beispiel etwa drei Volt) und von der Konstantstromquelle K1 bzw. von den Konstantstromquellen K1, K2 ab.

Bei der in Fig. 5C dargestellten dritten exemplarischen Treiberschaltung S3 gemäß dem Stand der Technik fließt in Abhängigkeit von der Stellung des den Strompegel steuernden Umschalters U durch das lichtemittierende Bauelement E der Strom I₁ + 0,5·I₂ oder der Strom I₁ - 0,5·I₂, das heißt auch hier beträgt die Stromdifferenz I₂.

Die Anordnung einer (nicht obligatorischen) Spule L, an der beispielsweise eine Spannung von etwa 0,5 Volt abfällt, dient üblicherweise der Impedanzerhöhung der Konstantstromquelle K1 bei hohen Frequenzen und ermöglicht demzufolge den Einsatz einer Konstantstromquelle K1, die keine hohe Ausgangsimpedanz bei hohen Frequenzen aufweist.

Neben der vorbeschriebenen Treiberschaltung S3 ist auch aus der Druckschrift US 6 667 661 B1 aus dem Stand der Technik eine Treiberschaltung mit Spule bekannt.

Unvorteilhafterweise erforderlich ist bei der in Fig. 5C dargestellten elektronischen Treiberschaltung S3 jedoch die Anordnung externer, das heißt außerhalb der integrierten Schaltung angeordneter Bauelemente, wie etwa eines Kondensators C.

Aufgrund der Anordnung aus Spule L und Kondensator C können des Weiteren unerwünschte elektromagnetische Störeffekte, wie etwa elektromagnetische Schwingungen, auftreten. Mit dem Problem der Vermeidung elektromagnetischer Schwingungen einer Lasertreiberschaltung mit signalverstärkter Datenübertragung befasst sich in diesem Zusammenhang beispielsweise die Druckschrift US 7 133 429 B2 aus dem Stand der Technik.

Ein weiterer Nachteil konventioneller Schaltungsanordnungen ist deren hoher Spannungsabfall an den, zum lichtemittierenden Bauelement in Reihe liegenden, Bauelementen. Insbesondere für Anwendungen bei denen nur eine kleine Versorgungsspannung zur Verfügung steht, steht dieses im Widerspruch zum Ziel, am lichtemittierenden Bauelement eine möglichst hohe Betriebsspannung bereit zu stellen.

Die technische Problemstellung, eine Treiberschaltung zur optischen Datenübertragung mit geringem Leistungsbedarf bereit zu stellen, ist beispielsweise aus den Druckschriften US 6 965 722 B1 sowie US 7 154 923 B2 aus dem Stand der Technik bekannt. Der Aufbau der in diesen Druckschriften beschriebenen Treiberschaltungen ist jedoch sehr komplex.

Zudem haben aus dem Stand der Technik bekannte Schaltungsanordnungen nachteiligerweise hohe Ausgangswiderstände (= Realteile der Ausgangsimpedanzen). Dies begrenzt die Geschwindigkeit, insbesondere für das Einschwingen (oder Settling) der Schaltungsanordnung, denn die maximale Schaltfrequenz f verhält sich im Wesentlichen reziprok proportional zum Produkt aus Gesamtkapazität C und Gesamtwiderstand R am Ausgang der Ansteuer- oder Treiberschaltung, wobei
- die Gesamtkapazität C zum Beispiel im Wesentlichen durch die parasitäre kapazitive Wirkung des lichtemittierenden Bauelements dominiert ist und
- der Gesamtwiderstand R im Wesentlichen durch die Parallelschaltung des Ausgangswiderstands der Treiberschaltung und des Eingangswiderstands des lichtemittierenden Bauelements gegeben ist.

Schließlich ist ein weiteres technisches Problem konventioneller Schaltungsanordnungen eine (zu) niedrige Ausgangsspannung am lichtemittierenden Bauelement, denn die Konstantstromquelle(n) benötigt/en eine(n) Spannung(sabfall) von beispielsweise etwa 0,5 Volt (ein geringer Spannungsabfall in Höhe von beispielsweise etwa 0,2 Volt erfolgt auch an der die Versorgungsspannung zur Verfügung stellenden Spannungsquelle, sofern es sich um eine geregelte Spannungsquelle handelt).

Ein weiterer geringer Spannungsabfall in Höhe von beispielsweise etwa 0,1 Volt erfolgt am Schaltelement U, so dass am lichtemittierenden Bauelement (zu) wenig Spannung abfällt und damit am lichtemittierenden Bauelement (zu) wenig Spannung zur Verfügung steht.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung der eingangs genannten Art sowie ein Verfahren der eingangs genannten Art so weiterzuentwickeln, dass die vorstehend dargelegten Nachteile und Unzulänglichkeiten vermieden werden; insbesondere sollen Strombedarf und Ausgangswiderstand möglichst niedrig sein, so dass eine möglichst hohe Frequenz oder Schaltgeschwindigkeit sowie eine möglichst hohe Ausgangsspannung für das lichtemittierende Bauelement erzielt werden können.

Diese Aufgabe wird durch eine Schaltungsanordnung mit den im Anspruch 1 angegebenen Merkmalen sowie durch ein Verfahren mit den im Anspruch 8 angegebenen Merkmalen gelöst.

Das spannungsbegrenzende Element verhält sich bei niedrigen Spannungen insbesondere
- nach Art mindestens einer in Vorwärtsrichtung gepolten Diode, wie etwa mindestens einer pn-Diode oder mindestens einer Schottky-Diode, oder
- nach Art mindestens eines spannungsabhängigen Widerstands mit nicht-linearer Kennlinie oder
- nach Art mindestens eines Varistors oder
- nach Art mindestens eines als Source-Folger geschalteten Transistors oder
- nach Art mindestens einer Zener-Diode.

Dies bedeutet, dass eine bevorzugte Ausführungsform des spannungsbegrenzenden Elements
- bei niedriger Spannung, insbesondere bei einer Spannung von kleiner als etwa ein Volt, zum Beispiel bei einer Spannung von kleiner als etwa 0,2 Volt, eine im Wesentlichen stromsperrende Wirkung aufweist und
- ab einem bestimmten Grenzwert oder Schwellwert der Spannung, insbesondere ab einer Durchbruchsspannung von etwa 0,2 Volt, einen starken Stromanstieg zulässt.

Das spannungsbegrenzende Element wird durch mindestens ein Schaltelement, insbesondere durch mindestens einen Einschalter oder durch mindestens einen Umschalter oder durch mindestens einen Wechselschalter, wie zum Beispiel mindestens einen Schalttransistor, etwa wie mindestens einen M[etal]O[xide]S[emiconductor]F[ield]E[ffect]T[ransistor], kurzgeschlossen werden. Auf diese Weise sind mindestens zwei Betriebszustände der Schaltungsanordnung mit jeweils niedrigen Impedanzen, insbesondere ohne weitere Stromverluste, erzielbar.

Erfindungsgemäß fällt in der ersten Schaltposition des Schaltelements die gesamte oder nahezu die gesamte vom Versorgungselement bereit gestellte Spannung am lichtemittierenden Bauelement ab; exemplarisch können in der ersten Schaltposition des Schaltelements mindestens etwa neunzig Prozent, zum Beispiel etwa 99 Prozent, der vom Versorgungselement bereit gestellten Spannung am lichtemittierenden Bauelement abfallen.

Ein Versorgungselement im Sinne der vorliegenden Erfindung kann als mindestens eine Spannungsquelle oder als Kombination aus Stromquelle und Stützkondensator realisiert sein, so dass für die relevanten Betriebsfrequenzen eine niedrige Ausgangsimpedanz entsteht.

Das lichtemittierende Bauelement ist somit durch Variieren seiner Betriebsspannung, also der auf das lichtemittierende Bauelement beaufschlagten Spannung, insbesondere der in das lichtemittierende Bauelement eingeprägten Spannung, ansteuerbar und kann beispielsweise zur optischen Datenübertragung dienen. Hierzu wandelt das lichtemittierende Bauelement elektrische Signale in optische Signale um, die in einen Lichtwellenleiter, beispielsweise in eine Glasfaser oder in eine Kunststofffaser, eingekoppelt werden.

Bei der vorliegenden Erfindung wird das lichtemittierende Bauelement somit spannungsgesteuert ("voltage-driven") in mindestens zwei Arbeitspunkten betrieben, die mittels des Schaltelements sowie optionalerweise mittels mindestens einer Steuerungseinrichtung, insbesondere mittels mindestens einer Signalquelle, zum Steuern des Schaltelements konfigurierbar sind.

Die erfindungsgemäße Schaltungsanordnung ist aufgrund ihres niedrigen Strombedarfs besonders vorteilhaft. Der Strombedarf ist besonders niedrig, weil es - im Unterschied zum Stand der Technik - außerhalb des lichtemittierenden Bauelements keinen weiteren Strompfad gibt.

Des Weiteren wird der Fachmann bei der vorliegenden Erfindung die vergleichsweise hohe, für das lichtemittierende Bauelement zur Verfügung stehende Ausgangsspannung besonders zu schätzen wissen.

Ferner ist die niedrige Ausgangsimpedanz ein weiterer Vorteil der vorliegenden Erfindung. Dies ermöglicht eine hohe Geschwindigkeit, insbesondere für das Einschwingen der Schaltungsanordnung, denn die maximale Schaltfrequenz f verhält sich im Wesentlichen reziprok proportional zum Produkt aus Gesamtkapazität C und Gesamtwiderstand R am Ausgang der Ansteuer- oder Treiberschaltung, wobei
- die Gesamtkapazität C zum Beispiel im Wesentlichen durch die parasitäre kapazitive Wirkung des lichtemittierenden Bauelements dominiert ist und
- der Gesamtwiderstand R im Wesentlichen durch die Parallelschaltung des Ausgangswiderstands der Treiberschaltung und des Eingangswiderstands des lichtemittierenden Bauelements gegeben ist.

Beim lichtemittierenden Bauelement *handelt* es sich um eine lichtemittierende Diode (= L[ight]E[mitting]D[iode]), wie etwa um eine Leuchtdiode, oder um einen Halbleiterlaser.

Das Ansteuern des lichtemittierenden Bauelements erfolgt zum Beispiel zum Zwecke der Datenübertragung von mindestens einem lichtemittierenden Bauelement (= sogenannte Quelle) zu mindestens einem lichtempfangenden Bauelement (= sogenannte Senke).

Die Datenübertragung kann zum Beispiel über mindestens ein Trägermedium, wie etwa über Glasfaser oder über Kunststofffaser, oder auch über Luft als Trägermedium oder durch Vakuum erfolgen.

Die vorliegende Erfindung betrifft schließlich die Verwendung mindestens einer Schaltungsanordnung nach Anspruch 1, insbesondere mindestens einer Treiberschaltung, gemäß der vorstehend dargelegten Art und/oder eines Verfahrens nach Anspruch 8 gemäß der vorstehend dargelegten Art
- in mindestens einer, insbesondere mobilen, Telekommunikationsanlage, zum Beispiel in mindestens einem Kommunikationsgerät, wie etwa in mindestens einem Mobiltelefon,
- in mindestens einer, insbesondere mobilen, Datenkommunikationsanlage oder in mindestens einer, insbesondere mobilen, Datenverarbeitungseinrichtung, zum Beispiel in mindestens einem Handheld, in mindestens einem Notebook oder in mindestens einem P[ersonal]D[igital]A[ssistant],
- in mindestens einer, insbesondere mobilen, Datenaufzeichnungs- und/oder -wiedergabeeinrichtung, zum Beispiel in mindestens einem Camcorder, in mindestens einer Digitalkamera oder in mindestens einem H[igh]D[efinition]T[ele]V[ision], oder
- in mindestens einem Fortbewegungsmittel, zum Beispiel in mindestens einem Fahrerassistenzsystem oder in mindestens einem Navigationssystem eines Automobils.

In einem mobilen Kommunikationsgerät oder in einer mobilen Datenverarbeitungseinrichtung ist die vorliegende Erfindung besonders vorteilhaft einsetzbar, denn bei diesen Anwendungsgebieten ist die durch die Batterie bzw. durch die Akkumulatoreneinheit, umgangssprachlich auch Akku, zur Verfügung gestellte Versorgungsspannung begrenzt; im Sinne einer möglichst langen Betriebszeit des Akkus ist ein durch die vorliegende Erfindung ermöglichter effizienter Umgang mit der Versorgungsspannung und der Leistungsaufnahme von besonderem Nutzen.

Im Ergebnis können durch das Ansteuern des lichtemittierenden Bauelements mittels Variieren seiner Betriebsspannung, also durch den vorliegenden spannungsgetriebenen ("voltage-driven") Ansatz gemäß der vorliegenden Erfindung ein sehr niedriger Ausgangswiderstand und damit eine sehr hohe Frequenz oder Schaltgeschwindigkeit erzielt werden.

Unabhängig hiervon kann bei der vorliegenden Erfindung eine sehr hohe Ausgangsspannung bzw. ein sehr geringer Ausgangswiderstand für das lichtemittierende Bauelement erzielt werden.

Im Vergleich zu konventionellen Schaltungsanordnungen aus dem Stand der Technik weist die Schaltungsanordnung gemäß der vorliegenden Erfindung einen deutlich geringeren Strombedarf auf, denn die Betriebsspannung des lichtemittierenden Bauelements wird mittels des spannungsbegrenzenden Elements variiert, wohingegen konventionellerweise die Betriebsspannung des lichtemittierenden Bauelements mittels mindestens zweier Stromquellen variiert wird.

Der Spannungsabfall über dem spannungsbegrenzenden Element ist deutlich geringer als der Spannungsabfall über den im Stand der Technik eingesetzten Stromquellen. Zudem muss bei der vorliegenden Erfindung zum Variieren der Betriebsspannung des lichtemittierenden Bauelements im Gegensatz zum Stand der Technik kein zweiter Strompfad aufgemacht werden; vielmehr kann gemäß der vorliegenden Erfindung die Betriebsspannung des lichtemittierenden Bauelements mittels mindestens eines spannungsbegrenzenden Elements variiert werden.

Der Fachmann auf dem technischen Gebiet der Ansteuerung von lichtemittierenden Bauelementen wird insbesondere zu schätzen wissen, dass die Schaltungsanordnung gemäß der vorliegenden Erfindung wie auch das Verfahren gemäß der vorliegenden Erfindung sowohl eine niedrige Ausgangsimpedanz als auch einen geringen Energiebedarf aufweisen.

### Kurze Beschreibung der Zeichnungen

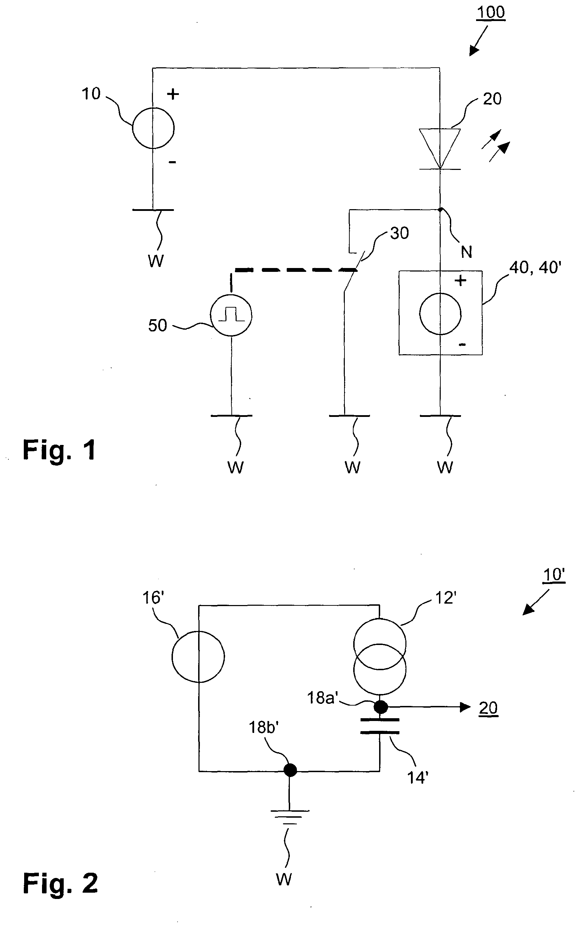

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 8 nachgeordneten Ansprüche verwiesen, andererseits werden weitere Ausgestaltungen, Merkmale und Vorteile der vorliegenden Erfindung nachstehend unter Anderem anhand der durch Fig. 1 bis Fig. 4 veranschaulichten Ausführungsbeispiele näher erläutert.

Es zeigt:
- Fig. 1: in schematischer Darstellung ein Ausführungsbeispiel einer Schaltungsanordnung gemäß der vorliegenden Erfindung, die nach dem Verfahren gemäß der vorliegenden Erfindung arbeitet;
- Fig. 2: in schematischer Darstellung ein zweites Ausführungsbeispiel eines Versorgungselements der Schaltungsanordnung aus Fig. 1;
- Fig. 3A: in schematischer Darstellung ein erstes Ausführungsbeispiel eines spannungsbegrenzenden Elements für die Schaltungsanordnung aus Fig. 1;
- Fig. 3B: in schematischer Darstellung ein zweites Ausführungsbeispiel eines spannungsbegrenzenden Elements für die Schaltungsanordnung aus Fig. 1;
- Fig. 4: in diagrammatischer Darstellung den nicht-linearen Widerstandseffekt des spannungsbegrenzenden Elements aus Fig. 3A oder aus Fig. 3B;
- Fig. 5A: in schematischer Darstellung ein erstes Ausführungsbeispiel einer Schaltungsanordnung gemäß dem Stand der Technik;
- Fig. 5B: in schematischer Darstellung ein zweites Ausführungsbeispiel einer Schaltungsanordnung gemäß dem Stand der Technik; und
- Fig. 5C: in schematischer Darstellung ein drittes Ausführungsbeispiel einer Schaltungsanordnung gemäß dem Stand der Technik.

Gleiche oder ähnliche Ausgestaltungen, Elemente oder Merkmale sind in Fig. 1 bis Fig. 5C mit identischen Bezugszeichen versehen.

### Bester Weg zur Ausführung der vorliegenden Erfindung

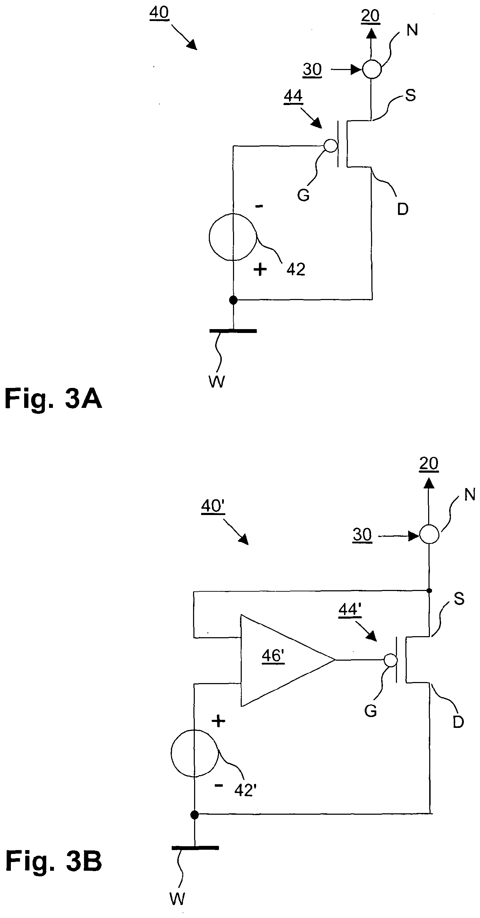

Zur Vermeidung überflüssiger Wiederholungen beziehen sich die nachfolgenden Erläuterungen hinsichtlich der Ausgestaltungen, Merkmale und Vorteile der vorliegenden Erfindung - soweit nicht anderweitig angegeben -
- sowohl auf die in Fig. 1 dargestellte Schaltungsanordnung 100 einschließlich des ersten Ausführungsbeispiels eines Versorgungselements 10
- als auch auf das in Fig. 2 dargestellte zweite Ausführungsbeispiel eines Versorgungselements 10'
- als auch auf das in Fig. 3A dargestellte erste Ausführungsbeispiel eines spannungsbegrenzenden Elements 40
- als auch auf das in Fig. 3B dargestellte zweite Ausführungsbeispiel eines spannungsbegrenzenden Elements 40'.

Im anhand Fig. 1 veranschaulichten Ausführungsbeispiel der vorliegenden Erfindung ist eine Schaltungsanordnung 100, nämlich eine Ansteuerschaltung oder Treiberschaltung, zum Ansteuern eines lichtemittierenden Bauelements 20, beispielsweise einer lichtemittierenden Diode (= L[ight]E[mitting]D[iode]) oder Leuchtdiode oder eines Lasers, zum Beispiel eines Halbleiterlasers, gezeigt.

Diese Schaltung 100 weist neben dem lichtemittierenden Bauelement 20 ein gegen ein Bezugspotential oder Referenzpotential W, insbesondere gegen Erdpotential oder Massepotential oder Nullpotential, betriebenes erstes Ausführungsbeispiel eines Versorgungselements 10, insbesondere eine Akkumulatoreneinheit, zur Spannungsversorgung der Schaltungsanordnung 100 auf.

Anstelle des in Fig. 1 gezeigten ersten Ausführungsbeispiels eines Versorgungselements 10, insbesondere einer Akkumulatoreneinheit, kann auch ein in Fig. 2 dargestelltes zweites Ausführungsbeispiel eines Versorgungselements 10' in Form einer ausgangsseitig kapazitiv gestützten Stromquelle vorgesehen sein, etwa als Kombination oder Zusammenschaltung aus für Anwendungen bei niedrigen Frequenzen optimierter Stromquelle 12' und Stützkondensator 14'. Zum Bereitstellen einer Versorgungsspannung 16' weist das Versorgungselement 10' eine Batterie auf.

Die Stromquelle 12' gemäß Fig. 2 dient hierbei zur bedarfsgemäßen Stromnachführung, zeichnet sich durch einen geringen Spannungsabfall aus und arbeitet gegen den "ruhigen", durch die Kapazität 14' gestützten Knoten 18a'.

Im Speziellen dient der Stützkondensator 14' dazu, die Impedanz des Knotens 18a' für den Bereich der Schalt- und Betriebsfrequenzen der Ansteuer- oder Treiberschaltung 100 zu verringern. Da sich eine Erhöhung der Kapazität am Knotenpunkt 18a' vorteilhaft auf die Stützwirkung an diesem Knotenpunkt 18a' auswirkt, ist bei der Dimensionierung der Stromquelle 12' im Prinzip keine Obergrenze für deren parasitäre Ausgangskapazität zu beachten.

Demzufolge kann die Stromquelle 12' so dimensioniert werden, dass sie auch bei sehr geringer Spannungsdifferenz zwischen der Spannungsversorgung 16' (sogenannte Urspannungsversorgung) und der Spannung am Knotenpunkt 18a' bestimmungsgemäß arbeitet.

Des Weiteren zeichnet sich das in Fig. 2 dargestellte zweite Ausführungsbeispiel eines Versorgungselements 10' dadurch aus, dass die Stromquelle 12' (im Gegensatz zum Stand der Technik, zum Beispiel gemäß Fig. 5A) nicht im hochfrequenten Signalpfad, sondern vorteilhafterweise im Versorgungspfad angeordnet ist, so dass im Signalpfad keine parasitären Kapazitäten auftreten; auch treten kein unerwünschter hoher Spannungsabfall bzw. keine hohe Sättigungsspannung auf.

Das Versorgungselement 10' gemäß Fig. 2 wird analog dem Versorgungselement 10 gemäß Fig. 1 in die zum Ansteuern des lichtemittierenden Bauelements 20 vorgesehene Ansteuer- oder Treiberschaltung 100 geschaltet.

Im Speziellen ist der zwischen Stromquelle 12' und Stützkapazität 14' angeordnete erste Anschluss oder erste Knoten 18a' des Versorgungselements 10' dem anzusteuernden lichtemittierenden Bauelement 20 zugeordnet; insbesondere mit dem anzusteuernden lichtemittierenden Bauelement 20 verbunden; der zwischen Stützkapazität 14' und Spannungsversorgung 16' angeordnete zweite Anschluss oder zweite Knoten 18b' des Versorgungselements 10' liegt auf dem Bezugspotential oder Referenzpotential W, insbesondere auf Erdpotential oder Massepotential oder Nullpotential.

Wie in Fig. 1 dargestellt, ist der Schaltungsanordnung 100 ferner ein Schaltelement 30, insbesondere ein Einschalter, zum Beispiel ein Schalttransistor, wie etwa ein M[etal]O[xide]S[emiconductor]-F[ield]E[ffect]T[ransistor], zugeordnet.

Das Schaltelement 30 ist zum Ansteuern des lichtemittierenden Bauelements 20 mittels Schaltens zumindest zwischen einer ersten Schaltposition und einer zweiten Schaltposition ausgebildet, wobei in der ersten (in Fig. 1 lediglich aus Gründen der Übersichtlichkeit der Darstellung nicht gezeigten) Schaltposition die gesamte oder nahezu die gesamte von der Spannungsquelle 10 bereit gestellte Spannung, insbesondere etwa neunzig Prozent, zum Beispiel etwa 99 Prozent, am lichtemittierenden Bauelement 20 abfällt.

Bei der zweiten (in Fig. 1 gezeigten) Schaltposition des Schaltelements 30 wird hingegen eine weitere Schaltungskomponente 40, nämlich ein zum Variieren der Betriebsspannung des lichtemittierenden Bauelements 20 bestimmtes spannungsbegrenzendes Element 40 aktiv geschaltet oder zugeschaltet.

Durch das Vorsehen dieses nach Art einer Konstantspannungsquelle (--> niedrige Ausgangsimpedanz) wirkenden spannungsbegrenzenden Elements 40 kann bei der Treiberschaltung 100 der Ausgangswiderstand sehr niedrig gehalten werden, so dass eine sehr hohe Betriebsfrequenz oder Schaltgeschwindigkeit erzielt werden kann.

Im besonderen Fall der vorliegenden Erfindung kann eine sehr hohe Ausgangsspannung für das lichtemittierende Bauelement 20 erzielt werden, denn über den Schalter 30 erfolgt nur ein sehr geringer Spannungsabfall; zudem ist die Stromquelle 12' vorteilhafterweise im Versorgungspfad und nicht im hochfrequenten Signalpfad angeordnet.

Beträgt beispielsweise die durch die Spannungsquelle 10 zur Verfügung gestellte Versorgungsspannung etwa 2,4 Volt, so beträgt der Spannungsabfall am elektrooptischen Wandler 20, das heißt am lichtemittierenden Bauelement in der zweiten Schaltposition, also bei geöffnetem Einschalter 30, etwa 2 Volt, und der Spannungsabfall am spannungsbegrenzenden Element 40 beträgt etwa 0,4 Volt.

Wird der Einschalter 30 geschlossen (= erste Schaltposition), wird das spannungsbegrenzende Element 40 kurzgeschlossen und der Spannungsabfall am lichtemittierenden Bauelement 20 springt auf etwa 2,4 Volt. Dies bedeutet, dass bei geschlossenem Einschalter 30 am lichtemittierenden Bauelement 20 nahezu die gesamte Versorgungsspannung (im Beispiel also ca. 2,4 Volt) der Spannungsquelle 10 zur Verfügung steht.

Beim in Fig. 1 dargestellten Ausführungsbeispiel ist das spannungsbegrenzende Element 40
- in der ersten Schaltposition parallel zum Schaltelement 30 und
- in der zweiten Schaltposition seriell zum lichtemittierenden Element 20
geschaltet.

Zum Steuern des Schaltens des Schaltelements 30 weist die Treiberschaltung 100 des Weiteren eine dem Schaltelement 30 zugeordnete Steuerungseinrichtung 50 auf, zum Beispiel in Form einer Signalquelle.

Das spannungsbegrenzende Element 40, 40' gemäß Fig. 1 kann beispielsweise
- wie im in Fig. 3A dargestellten ersten Ausführungsbeispiel (--> Bezugszeichen 40) oder
- wie im in Fig. 3B als Schaltungsanordnung dargestellten zweiten Ausführungsbeispiel (-- > Bezugszeichen 40')
realisiert sein.

Ein wesentliches Merkmal des spannungsbegrenzenden Elements, 40, 40' besteht darin, dass es bei niedrigen Spannungen einen Effekt
- nach Art mindestens eines Varistors oder
- nach Art mindestens einer in Vorwärtsrichtung gepolten Diode, wie etwa mindestens einer pn-Diode oder mindestens einer Schottky-Diode, oder
- nach Art mindestens eines als Source-Folger geschalteten Transistors oder
- nach Art mindestens einer Zener-Diode
aufweist.

Hierbei handelt es sich bei einer Zener-Diode oder Z-Diode um eine Halbleiterdiode, die in Sperrrichtung betrieben wird und bei Überschreiten einer bestimmten Spannung, der sogenannten Zener-Spannung, einen auf dem Avalanche-Effekt oder auf dem Zener-Effekt beruhenden sehr starken Stromanstieg zeigt. Dieser Stromanstieg ist in Fig. 4 mittels der Durchlasskennlinie Z veranschaulicht.

Der auf einer sprunghaften Änderung des Widerstandswerts der Zener-Diode basierende Zener-Effekt wird durch gezielte Dotierung des Halbleitermaterials (= meist im Wesentlichen Silizium) erzielt und kann bei Spannungen von wenigen Volt bis hin zu einigen hundert Volt liegen. Im in Fig. 4 dargestellten Beispiel liegt die sprunghafte Änderung Z des Widerstandswerts bei etwa fünf Volt bis etwa sechs Volt.

Im Gegensatz hierzu tritt beim spannungsbegrenzenden Element 40, 40' ein derartiger sprunghafter Stromanstieg bereits bei Spannungen von unter einem Volt, beispielsweise bei Spannungen von etwa 200 Millivolt, auf. Die Durchlasskennlinie des spannungsbegrenzenden Elements 40, 40' ist in Fig. 4 mit dem Bezugszeichen D versehen.

Dies bedeutet, dass das spannungsbegrenzende Element 40, 40'
- bei niedriger Spannung, insbesondere bei einer Spannung von kleiner als etwa ein Volt, zum Beispiel bei einer Spannung von kleiner als etwa 0,2 Volt, eine im Wesentlichen stromsperrende Wirkung aufweist und
- ab einem bestimmten Grenzwert oder Schwellwert der Spannung, insbesondere ab einer Durchbruchsspannung von etwa 0,2 Volt, einen starken Stromanstieg zulässt.

Zu diesem Zweck weist das spannungsbegrenzende Element 40 bzw. 40'
- ein Versorgungselement 42 bzw. 42', insbesondere eine Spannungsquelle oder eine ausgangsseitig kapazitiv gestützte Stromquelle, und
- einen Transistor 44 bzw. 44', insbesondere einen p-Kanal-Transistor, zum Beispiel einen p-Kanal-F[eld]E[ffekt]T[ransistor],
auf.

Der Transistor 44 bzw. 44' weist
- einen vom Versorgungselement 42 bzw. 42' mit Spannung beaufschlagten Gateanschluss G,
- einen Sourceanschluss S, der einem das lichtemittierende Bauelement 20, das Schaltelement 30 und das spannungsbegrenzende Element 40 bzw. 40' verknüpfenden, insbesondere niederohmschen, Knotenpunkt N zugewandt ist, und
- einen dem Bezugspotential oder Referenzpotential W, insbesondere Masse, zugewandten Drainanschluss D
auf.

Wenn die Source-Gate-Spannung (= von Source nach Gate gemessene Spannung) kleiner als die Einsatzspannung des Transistors 44, 44' ist, insbesondere wenn die am Gateanschluss G anliegende Spannung größer als die am Sourceanschluss S anliegende Spannung ist, weist der Transistor 44, 44' einen hohen Widerstand auf und sperrt.

Entsprechend öffnet sich der Transistor 44, 44' und weist einen geringen, insbesondere gegen Null gehenden, Widerstand auf, wenn die Source-Gate-Spannung (= von Source nach Gate gemessene Spannung) größer als die Einsatzspannung des Transistors 44, 44' ist, insbesondere wenn die am Gateanschluss G anliegende Spannung kleiner als die am Sourceanschluss S anliegende Spannung ist.

Ein konventioneller p-Kanal-Transistor weist eine Schwellwertspannung von etwa 400 Millivolt auf. Beim in Fig. 3A dargestellten Ausführungsbeispiel wird der p-Kanal-Transistor 44 nicht - wie bei einem konventionellen p-Kanal-Transistor - geerdet, sondern anstelle dessen mit einer negativer Spannung beaufschlagt.

Aufgrund des Beaufschlagens mit negativer Spannung hat der p-Kanal-Transistor 44 aus Fig. 3A seine (in Fig. 4 als Durchbruchkennlinie D veranschaulichte) Schwellspannungskennlinie bereits bei geringeren Spannungen als ein konventioneller p-Kanal-Transistor. Wird beispielsweise in den p-Kanal-Transistor 44 eine Spannung von etwa minus 200 Millivolt eingeprägt, so liegt seine Schwellwertspannung bei etwa 200 Millivolt.

Beim in Fig. 3B dargestellten Ausführungsbeispiel wird der Transistor 44' mit positiver Spannung, beispielsweise mit 200 Millivolt beaufschlagt. Das spannungsbegrenzende Element 40' weist ein Regelungs-/Verarbeitungselement 46', nämlich einen Verstärker und/oder Komparator auf.

Der Verstärker und/oder Komparator ist dazu ausgebildet,
- die am Sourceanschluss S des Transistors 44' anliegende Spannung zu ermitteln,
- die ermittelte Spannung mit der vom Versorgungselement 42' bereit gestellten Spannung zu vergleichen und
- den als Source-Folger geschalteten Transistor 44' zu aktivieren sowie zu öffnen, wenn die vom Versorgungselement 42' bereit gestellte Spannung kleiner als die am Sourceanschluss S des Transistors 44' anliegende Spannung ist.

Die Spannung am Knotenpunkt N wird also mittels des Verstärkers und/oder Komparators 46' mit einer vom Versorgungselement 42' bereit gestellten Hilfsspannung verglichen. Überschreitet die Spannung im Knotenpunkt N den Wert dieser Hilfsspannung, so erzeugt der Verstärker und/oder Komparator 46' ein Ansteuersignal, das den Transistor 44' so weit öffnet, dass die Spannung im Knotenpunkt N nicht weiter ansteigt.

Es sei darauf aufmerksam gemacht, dass der Begriff "Verbindung" im Rahmen der vorliegenden Erfindung auch Verbindungen oder Verbindungsarten umfasst, die durch zusätzlich eingebrachte Bauelemente oder Bauteile erfolgen.

### Bezugszeichenliste

- 100: Schaltungsanordnung, insbesondere Ansteuerschaltung oder Treiberschaltung (= Ausführungsbeispiel der vorliegenden Erfindung; vgl. Fig. 1)
- 10: Versorgungselement, insbesondere Spannungsquelle, beispielsweise Akkumulatoreneinheit, zum Versorgen der Schaltungsanordnung 100 mit Spannung, insbesondere mit Gleichspannung (= erstes Ausführungsbeispiel der vorliegenden Erfindung; vgl. Fig. 1)
- 10': Versorgungselement, insbesondere ausgangsseitig kapazitiv gestützte Stromquelle, beispielsweise Kombination aus Stromquelle 12' und Stützkondensator 14', zum Versorgen der Schaltungsanordnung 100 mit Spannung (= zweites Ausführungsbeispiel der vorliegenden Erfindung; vgl. Fig. 2)
- 12': Stromquelle des Versorgungselements 10' (= zweites Ausführungsbeispiel der vorliegenden Erfindung; vgl. Fig. 2)
- 14': Stützkondensator, insbesondere kapazitive Stützung, des Versorgungselements 10' (= zweites Ausführungsbeispiel der vorliegenden Erfindung; vgl. Fig. 2)
- 16': Spannungsversorgung, insbesondere Urspannung(sversorgung), zum Beispiel Batterie, des Versorgungselements 10' (= zweites Ausführungsbeispiel der vorliegenden Erfindung; vgl. Fig. 2)
- 18a': erster Anschluss oder erster Knoten 18a' des Versorgungselements 10' (= zweites Ausführungsbeispiel der vorliegenden Erfindung; vgl. Fig. 2)
- 18b': zweiter Anschluss oder zweiter Knoten 18a' des Versorgungselements 10' (= zweites Ausführungsbeispiel der vorliegenden Erfindung; vgl. Fig. 2)
- 20: lichtemittierendes Bauelement, insbesondere elektrooptischer Wandler, beispielsweise lichtemittierende Diode (= L[ight]E[mitting]D[iode]) bzw. Leuchtdiode oder Laser, wie etwa Halbleiterlaser (= Ausführungsbeispiel der vorliegenden Erfindung; vgl. Fig. 1)
- 30: Schaltelement, insbesondere Einschalter oder Umschalter oder Wechselschalter, beispielsweise Schalttransistor, wie etwa M[etal]O[xide]S[emiconductor]F[ield]E[ffect]T[ransistor], (= Ausführungsbeispiel der vorliegenden Erfindung; vgl. Fig. 1)
- 40: weitere Schaltungskomponente, insbesondere spannungsbegrenzendes Element oder Konstantspannungsquelle, beispielsweise nicht-linearer Widerstand (= erstes Ausführungsbeispiel der vorliegenden Erfindung; vgl. Fig. 1, Fig. 3A)
- 40': weitere Schaltungskomponente, insbesondere spannungsbegrenzendes Element oder Konstantspannungsquelle, beispielsweise nicht-linearer Widerstand (= zweites Ausführungsbeispiel der vorliegenden Erfindung; vgl. Fig. 1, Fig. 3B)
- 42: Versorgungselement, insbesondere Spannungsquelle oder ausgangsseitig kapazitiv gestützte Stromquelle, zum Versorgen der weiteren Schaltungskomponente 40 mit Spannung, insbesondere mit negativer Spannung, beispielsweise mit etwa minus 200 Millivolt (= erstes Ausführungsbeispiel der vorliegenden Erfindung; vgl. Fig. 3A)
- 42': Versorgungselement, insbesondere Spannungsquelle oder ausgangsseitig kapazitiv gestützte Stromquelle, zum Versorgen der weiteren Schaltungskomponente 40' mit Spannung, insbesondere mit positiver Spannung, beispielsweise mit etwa 200 Millivolt (= zweites Ausführungsbeispiel der vorliegenden Erfindung; vgl. Fig. 3B)
- 44: Transistor, insbesondere p-Kanal-Transistor, der weiteren Schaltungskomponente 40 (= erstes Ausführungsbeispiel der vorliegenden Erfindung; vgl. Fig. 3A)
- 44': Transistor, insbesondere p-Kanal-Transistor, der weiteren Schaltungskomponente 40' (= zweites Ausführungsbeispiel der vorliegenden Erfindung; vgl. Fig. 3B)
- 46': Regelungs- und/oder Verarbeitungselement, insbesondere Verstärker und/oder Komparator, der weiteren Schaltungskomponente 40' (= zweites Ausführungsbeispiel der vorliegenden Erfindung; vgl. Fig. 3B)
- 50: Steuerungseinrichtung, insbesondere Signalquelle, zum Steuern (des Schaltens) des Schaltelements 30, insbesondere Einschaltersteuerung oder Umschaltersteuerung oder Wechselschaltersteuerung (= Ausführungsbeispiel der vorliegenden Erfindung; vgl. Fig. 1)
- C: Kondensator (= drittes Beispiel aus dem Stand der Technik; vgl. Fig. 5C)
- D: Kennlinie, insbesondere Durchlasskennlinie, beispielsweise sprunghafte Änderung des Widerstandswerts, der weiteren Schaltungskomponente 40, 40' (= Ausführungsbeispiel der vorliegenden Erfindung; vgl. Fig. 4)
- E: lichtemittierendes Bauelement, insbesondere elektrooptischer Wandler, beispielsweise lichtemittierende Diode (= L[ight]E[mitting]D[iode]) bzw. Leuchtdiode oder Laser, wie etwa Halbleiterlaser (= Beispiele aus dem Stand der Technik; vgl. Fig. 5A, Fig. 5B, Fig. 5C)
- K1: weitere Schaltungskomponente, nämlich Konstantstromquelle für I₁ (= Beispiele aus dem Stand der Technik; vgl. Fig. 5A, Fig. 5B, Fig. 5C)
- K2: zweite weitere Schaltungskomponente, nämlich Konstantstromquelle für I₂ (= Beispiele aus dem Stand der Technik; vgl. Fig. 5A, Fig. 5B, Fig. 5C)
- K2': dritte weitere Schaltungskomponente, nämlich Konstantstromquelle für I₂/2 (= drittes Beispiel aus dem Stand der Technik; vgl. Fig. 5C)
- L: Spule (= drittes Beispiel aus dem Stand der Technik; vgl. Fig. 5C)
- N: Knotenpunkt, insbesondere niederohmscher Knotenpunkt, zwischen lichtemittierendem Bauelement 20, Schaltelement 30 und weiterer Schaltungskomponente 40, 40' (= Ausführungsbeispiel der vorliegenden Erfindung; vgl. Fig. 1, Fig. 3A, Fig. 3B)
- Q: Spannungsquelle, insbesondere Akkumulatoreneinheit oder Akku (= Beispiele aus dem Stand der Technik; vgl. Fig. 5A, Fig. 5B, Fig. 5C)
- R: Blindlast (= erstes Beispiel aus dem Stand der Technik; vgl. Fig. 5A)
- S1: Schaltungsanordnung (= erstes Beispiel aus dem Stand der Technik; vgl. Fig. 5A)
- S2: Schaltungsanordnung (= zweites Beispiel aus dem Stand der Technik; vgl. Fig. 5B)
- S3: Schaltungsanordnung (= drittes Beispiel aus dem Stand der Technik; vgl. Fig. 5C)
- T: Steuerungseinrichtung, insbesondere Signalquelle, zum Steuern (des Schaltens) des Schaltelements U, insbesondere Einschaltersteuerung oder Umschaltersteuerung oder Wechselschaltersteuerung (= Beispiele aus dem Stand der Technik; vgl. Fig. 5A, Fig. 5B, Fig. 5C)
- U: Schaltelement, insbesondere Einschalter oder Umschalter oder Wechselschalter (= Beispiele aus dem Stand der Technik; vgl. Fig. 5A, Fig. 5B, Fig. 5C)
- W: Bezugspotential oder Referenzpotential, insbesondere Erdpotential oder Massepotential oder Nullpotential
- Z: Kennlinie, insbesondere Durchlasskennlinie, beispielsweise sprunghafte Änderung des Widerstandswerts, einer Zener-Diode (= Beispiel aus dem Stand der Technik; vgl. Fig. 4)

## Patentansprüche

1. Schaltungsanordnung (100), insbesondere Treiberschaltung, zum Ansteuern mindestens eines als mindestens eine lichtemittierende Diode oder Leuchtdiode oder als mindestens ein Halbleiterlaser ausgebildeten lichtemittierenden Bauelements (20), wobei die Schaltungsanordnung (100) aufweist:
- mindestens ein als mindestens eine Spannungsquelle oder als mindestens eine ausgangsseitig kapazitiv gestützte Stromquelle ausgebildetes erstes Versorgungselement (10; 10') zum Versorgen der Schaltungsanordnung (100) mit Spannung und
- mindestens ein Schaltelement (30) zum Ansteuern des lichtemittierenden Bauelements (20) mittels Schaltens des Schaltelements (30) zumindest zwischen einer ersten Schaltposition und einer zweiten Schaltposition, wobei mindestens eine weitere Schaltungskomponente (40; 40') in der zweiten Schaltposition aktiv geschaltet oder zugeschaltet ist, wobei die weitere Schaltungskomponente (40; 40') mindestens ein zum Variieren der Betriebsspannung des lichtemittierenden Bauelements (20) bestimmtes spannungsbegrenzendes Element ist, das parallel zum Schaltelement (30) angeordnet ist,
- wobei in der ersten Schaltposition die gesamte oder nahezu die gesamte vom ersten Versorgungselement (10; 10') bereit gestellte Spannung am lichtemittierenden Bauelement (20) abfällt,
- wobei das spannungsbegrenzende Element (40; 40') in der ersten Schaltposition parallel zum Schaltelement (30) angeordnet ist,
- wobei das spannungsbegrenzende Element (40; 40') in der zweiten Schaltposition in Serie zum lichtemittierenden Element (20) angeordnet ist,
**dadurch gekennzeichnet,**
**dass** das spannungsbegrenzende Element (40; 40') mindestens ein als mindestens eine Spannungsquelle oder als mindestens eine ausgangsseitig kapazitiv gestützte Stromquelle ausgebildetes zweites Versorgungselement (42; 42') sowie mindestens einen Transistor (44; 44') aufweist, wobei der Transistor (44; 44')
-- einen vom zweiten Versorgungselement (42; 42') mit Spannung beaufschlagten Gateanschluss (G) und einen Sourceanschluss (S) aufweist, welcher Sourceanschluss (S) einem das lichtemittierende Bauelement (20), das Schaltelement (30) und das spannungsbegrenzende Element (40') verknüpfenden Knotenpunkt (N) zugewandt ist,
-- einen einem Bezugspotential oder Referenzpotential (W), insbesondere Masse, zugewandten Drainanschluss (D) aufweist,
-- einen hohen Widerstand aufweist und sperrt, wenn die Source-Gate-Spannung kleiner als die Einsatzspannung des Transistors (44; 44') ist, und
-- einen geringen Widerstand aufweist und sich öffnet, wenn die Source-Gate-Spannung größer als die Einsatzspannung des Transistors (44; 44') ist.

2. Schaltungsanordnung gemäß Anspruch 1, **dadurch gekennzeichnet, dass** das spannungsbegrenzende Element (40; 40')
- bei niedriger Spannung, insbesondere bei einer Spannung von kleiner als etwa ein Volt, zum Beispiel bei einer Spannung von kleiner als etwa 0,2 Volt, eine im Wesentlichen stromsperrende Wirkung aufweist und
- ab einem bestimmten Grenzwert oder Schwellwert der Spannung, insbesondere ab einer Durchbruchsspannung von etwa 0,2 Volt, einen starken Stromanstieg zulässt.

3. Schaltungsanordnung gemäß Anspruch 1 oder 2, **dadurch gekennzeichnet, dass** sich das spannungsbegrenzende Element (40; 40')
- nach Art mindestens einer in Vorwärtsrichtung gepolten Diode, wie etwa mindestens einer pn-Diode oder mindestens einer Schottky-Diode, oder
- nach Art mindestens eines spannungsabhängigen Widerstands mit nicht-linearer Kennlinie (D) oder
- nach Art mindestens eines Varistors
verhält.

4. Schaltungsanordnung gemäß mindestens einem der Ansprüche 1 bis 3, **dadurch gekennzeichnet, dass** der Transistor (44; 44') als mindestens ein p-Kanal-Transistor, zum Beispiel als mindestens ein p-Kanal-F[eld]E[ffekt]T[ransistor], ausgebildet ist.

5. Schaltungsanordnung gemäß Anspruch 4, **dadurch gekennzeichnet, dass** der Gateanschluss (G) vom zweiten Versorgungselement (42; 42') mit negativer Spannung, beispielsweise mit etwa minus 200 Millivolt, beaufschlagt wird und dass der Knotenpunkt (N) niederohmsch ist.

6. Schaltungsanordnung gemäß Anspruch 4 oder 5, **dadurch gekennzeichnet,**
- **dass** das spannungsbegrenzende Element (40') mindestens ein Regelungs- und/oder Verarbeitungselement (46'), insbesondere mindestens einen Verstärker und/oder mindestens einen Komparator, aufweist und
- **dass** das Regelungs- und/oder Verarbeitungselement (46') dazu ausgebildet ist,
- die am Sourceanschluss (S) des Transistors (44') anliegende Spannung zu ermitteln,
- die ermittelte Spannung mit der vom zweiten Versorgungselement (42') bereit gestellten Spannung zu vergleichen und
- den als Source-Folger geschalteten Transistor (44') zu aktivieren und zu öffnen, wenn die vom zweiten Versorgungselement (42') bereit gestellte Spannung kleiner als die am Sourceanschluss (S) des Transistors (44') anliegende Spannung ist.

7. Schaltungsanordnung gemäß mindestens einem der Ansprüche 1 bis 6, **gekennzeichnet durch** mindestens eine dem Schaltelement (30) zugeordnete Steuerungseinrichtung (50), insbesondere Signalquelle, zum Steuern des Schaltens des Schaltelements (30).

8. Verfahren zum Ansteuern mindestens eines als mindestens eine lichtemittierende Diode oder Leuchtdiode oder als mindestens ein Halbleiterlaser ausgebildeten lichtemittierenden Bauelements (20) mittels mindestens einer Schaltungsanordnung (100) gemäß einem der Ansprüche 1 bis 7, durch Schalten mindestens eines Schaltelements (30) zumindest zwischen einer ersten Schaltposition und einer zweiten Schaltposition, wobei in der zweiten Schaltposition mindestens eine parallel zum Schaltelement (30) angeordnete weitere Schaltungskomponente (40; 40') in Form mindestens eines mindestens ein zweites Versorgungselement (42; 42') sowie mindestens einen Transistor (44; 44') aufweisenden spannungsbegrenzenden Elements aktiv geschaltet oder zugeschaltet wird, um das lichtemittierende Bauelement (20) durch Variieren seiner Betriebsspannung anzusteuern, nämlich durch Aktivschalten oder Zuschalten der weiteren Schaltungskomponente (40; 40') die Betriebsspannung des lichtemittierenden Bauelements (20) zu begrenzen.

9. Verfahren gemäß Anspruch 8, **dadurch gekennzeichnet, dass** das lichtemittierende Bauelement (20) in der ersten Schaltposition mit der gesamten oder mit nahezu der gesamten von mindestens einem ersten Versorgungselement (10; 10'), insbesondere von mindestens einer Spannungsquelle oder von mindestens einer ausgangsseitig kapazitiv gestützten Stromquelle, bereit gestellten Spannung beaufschlagt wird.

10. Verfahren gemäß Anspruch 8 oder 9, **dadurch gekennzeichnet, dass** sich die weitere Schaltungskomponente (40; 40')
- nach Art mindestens einer in Vorwärtsrichtung gepolten Diode, wie etwa mindestens einer pn-Diode oder mindestens einer Schottky-Diode, oder
- nach Art mindestens eines spannungsabhängigen Widerstands mit nicht-linearer Kennlinie (D) oder
- nach Art mindestens eines Varistors
verhält.

11. Verwendung mindestens einer Schaltungsanordnung (100), insbesondere mindestens einer Treiberschaltung, gemäß einem der Ansprüche 1 bis 7 und/oder eines Verfahrens gemäß einem der Ansprüche 8 bis 10,
wobei die Schaltungsanordnung (100) aufweist:
- mindestens ein als mindestens eine Spannungsquelle oder als mindestens eine ausgangsseitig kapazitiv gestützte Stromquelle ausgebildetes erstes Versorgungselement (10; 10') zum Versorgen der Schaltungsanordnung (100) mit Spannung und
- mindestens ein Schaltelement (30) zum Ansteuern des lichtemittierenden Bauelements (20) mittels Schaltens des Schaltelements (30) zumindest zwischen einer ersten Schaltposition und einer zweiten Schaltposition, wobei mindestens eine weitere Schaltungskomponente (40; 40') in der zweiten Schaltposition aktiv geschaltet oder zugeschaltet ist, wobei die weitere Schaltungskomponente (40; 40') mindestens ein zum Variieren der Betriebsspannung des lichtemittierenden Bauelements (20) bestimmtes spannungsbegrenzendes Element ist, das parallel zum Schaltelement (30) angeordnet ist,
- wobei in der ersten Schaltposition die gesamte oder nahezu die gesamte vom ersten Versorgungselement (10; 10') bereit gestellte Spannung am lichtemittierenden Bauelement (20) abfällt,
- wobei das spannungsbegrenzende Element (40; 40') in der ersten Schaltposition parallel zum Schaltelement (30) angeordnet ist,
- wobei das spannungsbegrenzende Element (40; 40') in der zweiten Schaltposition in Serie zum lichtemittierenden Element (20) angeordnet ist und
wobei das spannungsbegrenzende Element (40; 40') mindestens ein als mindestens eine Spannungsquelle oder als mindestens eine ausgangsseitig kapazitiv gestützte Stromquelle ausgebildetes zweites Versorgungselement (42; 42') sowie mindestens einen Transistor (44; 44') aufweist, wobei der Transistor (44; 44')
-- einen vom zweiten Versorgungselement (42; 42') mit Spannung beaufschlagten Gateanschluss (G) und einen Sourceanschluss (S) aufweist, welcher Sourceanschluss (S) einem das lichtemittierende Bauelement (20), das Schaltelement (30) und das spannungsbegrenzende Element (40') verknüpfenden Knotenpunkt (N) zugewandt ist,
-- einen einem Bezugspotential oder Referenzpotential (W), insbesondere Masse, zugewandten Drainanschluss (D) aufweist,
-- einen hohen Widerstand aufweist und sperrt, wenn die Source-Gate-Spannung kleiner als die Einsatzspannung des Transistors (44; 44') ist, und
-- einen geringen Widerstand aufweist und sich öffnet, wenn die Source-Gate-Spannung größer als die Einsatzspannung des Transistors (44; 44') ist,
wobei das Verfahren zum Ansteuern des mindestens einen als mindestens eine lichtemittierende Diode oder Leuchtdiode oder als mindestens ein Halbleiterlaser ausgebildeten lichtemittierenden Bauelements (20) mittels der mindestens einen Schaltungsanordnung (100), insbesondere mittels der mindestens einen Treiberschaltung, durch Schalten des mindestens einen Schaltelements (30) zumindest zwischen der ersten Schaltposition und der zweiten Schaltposition, wobei in der zweiten Schaltposition die mindestens eine parallel zum Schaltelement (30) angeordnete weitere Schaltungskomponente (40; 40') in Form des mindestens einen das mindestens eine zweite Versorgungselement (42; 42') sowie den mindestens einen Transistor (44; 44') aufweisenden spannungsbegrenzenden Elements aktiv geschaltet oder zugeschaltet wird, um das lichtemittierende Bauelement (20) durch Variieren seiner Betriebsspannung anzusteuern, nämlich durch Aktivschalten oder Zuschalten der weiteren Schaltungskomponente (40; 40') die Betriebsspannung des lichtemittierenden Bauelements (20) zu begrenzen,
- in mindestens einer, insbesondere mobilen, Telekommunikationsanlage, zum Beispiel in mindestens einem Kommunikationsgerät, wie etwa in mindestens einem Mobiltelefon,
- in mindestens einer, insbesondere mobilen, Datenkommunikationsanlage oder in mindestens einer, insbesondere mobilen, Datenverarbeitungseinrichtung, zum Beispiel in mindestens einem Handheld, in mindestens einem Notebook oder in mindestens einem P[ersonal]D[igital]A[ssistant],
- in mindestens einer, insbesondere mobilen, Datenaufzeichnungs- und/oder -wiedergabeeinrichtung, zum Beispiel in mindestens einem Camcorder, in mindestens einer Digitalkamera oder in mindestens einem H[igh]D[efinition]T[ele]V[ision], oder
- in mindestens einem Fortbewegungsmittel, zum Beispiel in mindestens einem Fahrerassistenzsystem oder in mindestens einem Navigationssystem eines Automobils.

## Claims

1. A circuit arrangement (100), in particular a driver circuit, for controlling at least one light-emitting component (20), said light-emitting component (20) being embodied as at least one light-emitting diode or electroluminescent diode or as at least one semiconductor laser, wherein the circuit arrangement (100) comprises:
- at least one first supply element (10; 10') for supplying the circuit arrangement (100) with voltage, said supply element (10; 10') being embodied as at least one voltage source or as at least one current source capacitively supported on the output side, and
- at least one switching element (30) for controlling the light-emitting component (20) by means of switching the switching element (30) at least between a first switching position and a second switching position, wherein at least one further circuit component (40; 40') is switched to active or switched on in the second switching position, wherein the further circuit component (40; 40') is at least one voltage-limiting element provided for varying the operating voltage of the light-emitting component (20), said voltage-limiting element being arranged in parallel to the switching element (30),
- wherein in the first switching position the entire or almost the entire voltage provided by the first supply element (10; 10') drops across the light-emitting component (20),
- wherein in the first switching position the voltage-limiting element (40; 40') is arranged in parallel to the switching element (30),
- wherein in the second switching position the voltage-limiting element (40; 40') is arranged in series to the light-emitting component (20),
**characterized in**
**that** the voltage-limiting element (40; 40') comprises at least one second supply element (42; 42'), said second supply element (42; 42') being embodied as at least one voltage source or as at least one current source capacitively supported on the output side, and at least one transistor (44; 44'), wherein transistor (44; 44')
-- comprises a gate terminal (G) supplied with a voltage by the second supply element (42; 42'), and a source terminal (S) assigned to an node point (N) connecting the light-emitting component (20), the switching element (30) and the voltage-limiting element (40'),
-- comprises a drain terminal (D) assigned to a ground potential or reference potential (W), in particular ground,
-- features a high resistance and blocks when the source gate voltage is smaller than the threshold voltage of the transistor (44, 44'), and
-- features a low resistance and opens when the source gate voltage is greater than the threshold voltage of the transistor (44, 44').

2. The circuit arrangement according to claim 1, **characterized in that** the voltage-limiting element (40; 40')
- features a substantially current-blocking effect at a low voltage, in particular at a voltage smaller than about one volt, for example at a voltage smaller than about 0.2 volt, and
- allows for a strong current rise starting from a certain critical value or threshold value of the voltage, in particular starting from a breakdown voltage of about 0.2 volt.

3. The circuit arrangement according to claim 1 or 2, **characterized in that** the voltage-limiting element (40; 40') behaves
- like at least one diode polarized in the forward direction, such as at least one pn diode or at least one Schottky diode, or
- like at least one voltage-dependent resistance with a non-linear characteristic (D), or
- like at least one varistor.

4. The circuit arrangement according to at least one of claims 1 to 3, **characterized in that** the transistor (44; 44') is embodied as at least one p-channel transistor, for example as at least one p-channel F[ield]E[ffect]T[ransistor].

5. The circuit arrangement according to claim 4, **characterized in that** the gate terminal (G) is supplied by the second supply element (42; 42') with a negative voltage, for example with about minus 200 millivolts, and that the node point (N) is of low-resistance.

6. The circuit arrangement according to claim 4 or 5, **characterized in**
- **that** the voltage-limiting element (40') comprises at least one regulating and/or processing element (46'), in particular at least one amplifier and/or at least one comparator, and
- **that** the regulating and/or processing element (46') is configured
- to determine the voltage present at the source terminal (S) of the transistor (44'),
- to compare the determined voltage with the voltage provided by the second supply element (42'), and
- to activate and to open the transistor (44') connected as a source follower, when the voltage provided by the second supply element (42') is smaller than the voltage present at the source terminal (S) of the transistor (44').

7. The circuit arrangement according to at least one of claims 1 to 6, **characterized by** at least one control device (50), in particular signal source, for controlling the switching of the switching element (30), said control device (50) being assigned to the switching element (30).

8. A method for controlling at least one light-emitting component (20) by means of at least one circuit arrangement (100) according to one of claims 1 to 7, said light-emitting component (20) being embodied as at least one light-emitting diode or electroluminescent diode or as at least one semiconductor laser, by switching at least one switching element (30) at least between a first switching position and a second switching position, wherein at least one further circuit component (40; 40') is switched to active or switched on in the second switching position in order to control the light-emitting component (20) by varying its operating voltage, namely to limit the operating voltage of the light-emitting component (20) by switching to active or switching on the further circuit component (40; 40'), said further circuit component (40; 40') being arranged in parallel to the switching element (30) and being in the form of at least one voltage-limiting element comprising at least one second supply element (42; 42') and at least one transistor (44; 44').

9. The method according to claim 8, **characterized in that**, in the first switching position, the light-emitting component (20) is supplied with the entire or with almost the entire voltage provided by at least one first supply element (10; 10'), in particular by at least one voltage source or by at least one current source capacitively supported on the output side.

10. The method according to claim 8 or 9, **characterized in that** the further circuit component (40; 40') behaves
- like at least one diode polarized in the forward direction, such as at least one pn diode or at least one Schottky diode, or
- like at least one voltage-dependent resistance with a non-linear characteristic (D), or
- like at least one varistor.

11. A use of at least one circuit arrangement (100), in particular of at least one driver circuit, according to one of claims 1 to 7 and/or of a method according to one of claims 8 to 10,
wherein the circuit arrangement (100) comprises:
- at least one first supply element (10; 10') for supplying the circuit arrangement (100) with voltage, said supply element (10; 10') being embodied as at least one voltage source or as at least one current source capacitively supported on the output side, and
- at least one switching element (30) for controlling the light-emitting component (20) by means of switching the switching element (30) at least between a first switching position and a second switching position, wherein at least one further circuit component (40; 40') is switched to active or switched on in the second switching position, wherein the further circuit component (40; 40') is at least one voltage-limiting element provided for varying the operating voltage of the light-emitting component (20), said voltage-limiting element being arranged in parallel to the switching element (30),
- wherein in the first switching position the entire or almost the entire voltage provided by the first supply element (10; 10') drops across the light-emitting component (20),
- wherein in the first switching position the voltage-limiting element (40; 40') is arranged in parallel to the switching element (30),
- wherein in the second switching position the voltage-limiting element (40; 40') is arranged in series to the light-emitting component (20), and
wherein the voltage-limiting element (40; 40') comprises at least one second supply element (42; 42'), said second supply element (42; 42') being embodied as at least one voltage source or as at least one current source capacitively supported on the output side, and at least one transistor (44; 44'), wherein transistor (44; 44')
-- comprises a gate terminal (G) supplied with a voltage by the second supply element (42; 42'), and a source terminal (S) assigned to an node point (N) connecting the light-emitting component (20), the switching element (30) and the voltage-limiting element (40'),
-- comprises a drain terminal (D) assigned to a ground potential or reference potential (W), in particular ground,
-- features a high resistance and blocks when the source gate voltage is smaller than the threshold voltage of the transistor (44, 44'), and
-- features a low resistance and opens when the source gate voltage is greater than the threshold voltage of the transistor (44, 44'),
wherein the method for controlling the at least one light-emitting component (20) by means of the at least one circuit arrangement (100), in particular by means of the at least one driver circuit, said light-emitting component (20) being embodied as at least one light-emitting diode or electroluminescent diode or as at least one semiconductor laser, by switching the at least one switching element (30) at least between the first switching position and the second switching position, wherein the at least one further circuit component (40; 40') is switched to active or switched on in the second switching position in order to control the light-emitting component (20) by varying its operating voltage, namely to limit the operating voltage of the light-emitting component (20) by switching to active or switching on the further circuit component (40; 40'), said further circuit component (40; 40') being arranged in parallel to the switching element (30) and being in the form of the at least one voltage-limiting element comprising the at least one second supply element (42; 42') and the at least one transistor (44; 44'),
- in at least one, in particular mobile, telecommunication system, for example in at least one communication device, such as in at least one mobile telephone,
- in at least one, in particular mobile, data communication system or in at least one, in particular mobile, data processing device, for example in at least one handheld, in at least one notebook or in at least one P[ersonla]D[igital]A[ssistant],
- in at least one, in particular mobile, data recording and/or reproducing device, for example in at least one camcorder, in at least one digital camera or in at least one H[igh]D[efinition]T[ele]V[ision], or
- in at least one transportation means, for example in at least one driver assistance system or in at least one navigation system of an automobile.

## Revendications

1. Arrangement de circuit (100), en particulier circuit de commande, pour commander au moins un composant émetteur de lumière (20) formé comme au moins une diode émettrice de lumière ou diode électroluminescente ou comme au moins un laser à semi-conducteur, l'arrangement de circuit (100) comportant :
- au moins un premier élément d'alimentation (10 ; 10') pour alimenter le circuit (100) en tension, ledit élément d'alimentation (10 ; 10') formé comme au moins une source de tension ou comme au moins une source de courant à support capacitif côté sortie, et
- au moins un élément de commutation (30) pour entraîner le composant émetteur de lumière (20) en commutant l'élément de commutation (30) au moins entre une première position de commutation et une deuxième position de commutation, au moins un autre composant du circuit (40 ; 40') étant commuté ou connecté activement dans la deuxième position de commutation, l'autre composant du circuit (40 ; 40') étant au moins un élément limiteur de tension destiné à faire varier la tension de fonctionnement du composant émetteur de lumière (20) et disposé parallèlement à l'élément de commutation (30),
- la totalité ou la quasi-totalité de la tension fournie par le premier élément d'alimentation (10 ; 10') chutant aux bornes du composant émetteur de lumière (20) dans la première position de commutation,
- l'élément limiteur de tension (40 ; 40') étant disposé parallèlement à l'élément de commutation (30) dans la première position de commutation,
- l'élément limiteur de tension (40 ; 40') étant disposé en série avec le composant émetteur de lumière (20) dans la deuxième position de commutation,
**caractérisé en ce**
**que** l'élément limiteur de tension (40 ; 40') comporte au moins un deuxième élément d'alimentation (42 ; 42') formé comme au moins une source de tension ou comme au moins une source de courant à support capacitif côté sortie et au moins un transistor (44 ; 44'), ledit transistor (44 ; 44')
-- comportant une borne de grille (G) alimentée en tension par le deuxième élément d'alimentation (42 ; 42') et une borne de source (S), ladite borne de source (S) étant affectée à un nœud (N) reliant le composant émetteur de lumière (20), l'élément de commutation (30) et l'élément limiteur de tension (40'),
-- comportant une borne de drainage (D) affectée à un potentiel de référence ou potentiel référentiel (W), en particulier la terre,
-- ayant une résistance élevée et se bloquant lorsque la tension source-grille est inférieure à la tension de fonctionnement du transistor (44 ; 44') et
-- ayant une faible résistance et s'ouvrant lorsque la tension source-grille est supérieure à la tension de fonctionnement du transistor (44 ; 44').

2. Arrangement de circuit selon la revendication 1, **caractérisé en ce que** l'élément limiteur de tension (40 ; 40')
- présente un effet essentiellement bloquant le courant à basse tension, en particulier à une tension inférieure à environ un volt, par exemple à une tension inférieure à environ 0,2 volt, et
- permet une forte augmentation du courant à partir d'une certaine limite ou valeur seuil de la tension, en particulier à partir d'une tension de claquage d'environ 0,2 volt.

3. Arrangement de circuit selon la revendication 1 ou 2, **caractérisé en ce que** l'élément limiteur de tension (40 ; 40') se comporte
- du type d'au moins une diode à polarisation directe, telle qu'au moins une diode pn ou au moins une diode Schottky, ou
- du type d'au moins une résistance dépendante de la tension avec une caractéristique non linéaire (D) ou
- du type d'au moins une varistance.

4. Arrangement de circuit selon au moins l'une des revendications 1 à 3, **caractérisé en ce que** le transistor (44 ; 44') est formé comme au moins un transistor à canal p, par exemple comme au moins un transistor à effet de champ à canal p.

5. Arrangement de circuit selon la revendication 4, **caractérisé en ce que** la borne de grille (G) est alimentée en tension négative, par exemple en environ moins 200 millivolts, par le deuxième élément d'alimentation (42 ; 42') et que le nœud (N) est de faible résistance.

6. Arrangement de circuit selon la revendication 4 ou 5, **caractérisé en ce**
- **que** l'élément limiteur de tension (40') comporte au moins un élément de contrôle et/ou de traitement (46'), en particulier au moins un amplificateur et/ou au moins un comparateur, et
- **que** l'élément de contrôle et/ou de traitement (46') est conçu
- pour déterminer la tension appliquée à la borne de source (S) du transistor (44'),
- pour comparer la tension déterminée avec la tension fournie par le deuxième élément d'alimentation (42') et
- pour activer et pour ouvrir le transistor (44') connecté en tant que source suiveuse lorsque la tension fournie par le deuxième élément d'alimentation (42') est inférieure à la tension appliquée à la borne de source (S) du transistor (44').

7. Arrangement de circuit selon au moins l'une des revendications 1 à 6, **caractérisé par** au moins un dispositif de commande (50), en particulier une source de signaux, pour commander la commutation de l'élément de commutation (30), ledit dispositif de commande (50) associé à l'élément de commutation (30).

8. Procédé pour commander au moins un composant émetteur de lumière (20) formé comme au moins une diode émettrice de lumière ou diode électroluminescente ou comme au moins un laser à semi-conducteur au moyen d'au moins un arrangement de circuit (100) selon l'une des revendications 1 à 7 en commutant au moins un élément de commutation (30) au moins entre une première position de commutation et une deuxième position de commutation, au moins un autre composant de circuit (40 ; 40') étant disposé parallèlement à l'élément de commutation (30) sous la forme d'au moins un élément limiteur de tension comportant au moins un deuxième élément d'alimentation (42 ; 42') et au moins un transistor (44 ; 44'), ledit autre composant de circuit (40 ; 40') étant commuté ou connecté activement dans la deuxième position de commutation pour commander le composant émetteur de lumière (20) en faisant varier sa tension de fonctionnement, à savoir en activant ou en mettant en marche l'autre composant du circuit (40 ; 40') pour limiter la tension de fonctionnement du composant émetteur de lumière (20).

9. Procédé selon la revendication 8, **caractérisé en ce que**, dans la première position de commutation, le composant émetteur de lumière (20) est alimenté avec la totalité ou la quasi-totalité de la tension fournie par au moins un premier élément d'alimentation (10 ; 10'), en particulier par au moins une source de tension ou par au moins une source de courant à support capacitif côté sortie.

10. Procédé selon la revendication 8 ou 9, **caractérisé en ce que** l'autre composant de circuit (40 ; 40') se comporte
- du type d'au moins une diode à polarisation directe, telle qu'au moins une diode pn ou au moins une diode Schottky, ou
- du type d'au moins une résistance dépendante de la tension avec une caractéristique non linéaire (D) ou
- du type d'au moins une varistance.

11. Utilisation d'au moins un arrangement de circuit (100), en particulier d'au moins un circuit de commande, selon l'une des revendications 1 à 7 et/ou d'un procédé selon l'une des revendications 8 à 10,
l'arrangement de circuit (100) comprenant :
- au moins un premier élément d'alimentation (10 ; 10') pour alimenter le circuit (100) en tension, ledit élément d'alimentation (10 ; 10') formé comme au moins une source de tension ou comme au moins une source de courant à support capacitif côté sortie, et
- au moins un élément de commutation (30) pour entraîner le composant émetteur de lumière (20) en commutant l'élément de commutation (30) au moins entre une première position de commutation et une deuxième position de commutation, au moins un autre composant du circuit (40 ; 40') étant commuté ou connecté activement dans la deuxième position de commutation, l'autre composant du circuit (40 ; 40') étant au moins un élément limiteur de tension destiné à faire varier la tension de fonctionnement du composant émetteur de lumière (20) et disposé parallèlement à l'élément de commutation (30),
- la totalité ou la quasi-totalité de la tension fournie par le premier élément d'alimentation (10 ; 10') chutant aux bornes du composant émetteur de lumière (20) dans la première position de commutation,
- l'élément limiteur de tension (40 ; 40') étant disposé parallèlement à l'élément de commutation (30) dans la première position de commutation,
- l'élément limiteur de tension (40 ; 40') étant disposé en série avec le composant émetteur de lumière (20) dans la deuxième position de commutation et
l'élément limiteur de tension (40 ; 40') comportant au moins un deuxième élément d'alimentation (42 ; 42') formé comme au moins une source de tension ou comme au moins une source de courant à support capacitif côté sortie et au moins un transistor (44 ; 44'), ledit transistor (44 ; 44')
-- comportant une borne de grille (G) alimentée en tension par le deuxième élément d'alimentation (42 ; 42') et une borne de source (S), ladite borne de source (S) étant affectée à un nœud (N) reliant le composant émetteur de lumière (20), l'élément de commutation (30) et l'élément limiteur de tension (40'),
-- comportant une borne de drainage (D) affectée à un potentiel de référence ou potentiel référentiel (W), en particulier la terre,
-- ayant une résistance élevée et se bloquant lorsque la tension source-grille est inférieure à la tension de fonctionnement du transistor (44 ; 44') et
-- ayant une faible résistance et s'ouvrant lorsque la tension source-grille est supérieure à la tension de fonctionnement du transistor (44 ; 44'),
le procédé pour commander l'au moins un composant émetteur de lumière (20) formé comme au moins une diode émettrice de lumière ou diode électroluminescente ou comme au moins un laser à semi-conducteur au moyen de l'au moins un arrangement de circuit (100), en particulier de l'au moins un circuit de commande, en commutant l'au moins un élément de commutation (30) au moins entre la première position de commutation et la deuxième position de commutation, l'au moins un autre composant de circuit (40 ; 40') étant disposé parallèlement à l'élément de commutation (30) sous la forme de l'au moins un élément limiteur de tension comportant l'au moins un deuxième élément d'alimentation (42 ; 42') et l'au moins un transistor (44 ; 44'), ledit autre composant de circuit (40 ; 40') étant commuté ou connecté activement dans la deuxième position de commutation pour commander le composant émetteur de lumière (20) en faisant varier sa tension de fonctionnement, à savoir en activant ou en mettant en marche l'autre composant du circuit (40 ; 40') pour limiter la tension de fonctionnement du composant émetteur de lumière (20),
- dans au moins un système de télécommunication, en particulier mobile, par exemple dans au moins un appareil de communication, comme dans au moins un téléphone portable,
- dans au moins un système de communication de données, en particulier mobile, ou dans au moins un dispositif de traitement de données, en particulier mobile, par exemple dans au moins un appareil portatif, dans au moins un notebook ou dans au moins un assistant numérique personnel (P[ersonal]D[igital]A[ssistant]),
- dans au moins un dispositif d'enregistrement et/ou de reproduction de données, en particulier mobile, par exemple dans au moins un caméscope, dans au moins une caméra numérique ou dans au moins une télévision haute définition (H[igh]D[efinition]T[ele]V[ision]), ou
- dans au moins un moyen de déplacement, par exemple dans au moins un système d'assistance à la conduite ou dans au moins un système de navigation d'une automobile.
